# EUROPEAN PATENT APPLICATION

(11) **EP 0 932 071 A2**
(43) Date of publication of application: **28.07.1999**
(21) Application number: 99201345.8
(22) Date of filing: 22.12.1995
(51) Int. Cl.: G02F 1/1335

(54) **Manufacturing method of colour liquid crystal display**

(30) Priority: 22.12.1994 JP 32098994
(62) Divisional of application: 95309428.1
(71) Applicant: SEIKO INSTRUMENTS INC., Chiba-shi, Chiba 261 (JP); SHINTO PAINT COMPANY, LIMITED, Amagasaki-shi Hyogo 661 (JP)
(72) Inventor: Suginoya, Mitsuru, Seiko Instruments Inc., Chiba-shi, Chiba (JP); Motte, Shunichi, Seiko Instruments Inc., Chiba-shi, Chiba (JP); Fukuchi, Takakazu, Seiko Instruments Inc., Chiba-shi, Chiba (JP); Kamamori, Hitoshi, Seiko Instruments Inc., Chiba-shi, Chiba (JP); Okada, Yoshikatsu, Shinto Paint Co. Ltd., Amagasaki-shi, Hyogo (JP); Sakurai, Akiko, Shinto Paint Co. Ltd., Amagasaki-shi, Hyogo (JP)
(74) Representative: Sturt, Clifford Mark

(57) **Abstract**

This invention allows the high image quality multicolour liquid crystal display to be manufactured by a simple method in which colour filters (3, 24, 34) are applied by patterning an insulating resist (23, 33) on a plurality of electrodes (2, 22, 32) formed on a substrate (1, 21, 31) by forming colour filters one after another by way of electro-deposition and by patterning a light shielding substance at gaps of the colour filters by utilising the colour filters as masks.

## Description

The present invention relates to a method for manufacturing a colour liquid crystal display in which colour liquid crystal display in which colour filters are applied, and more particularly, but not exclusively, to a simple method for manufacturing an active matrix colour liquid crystal display presenting a high image quality.

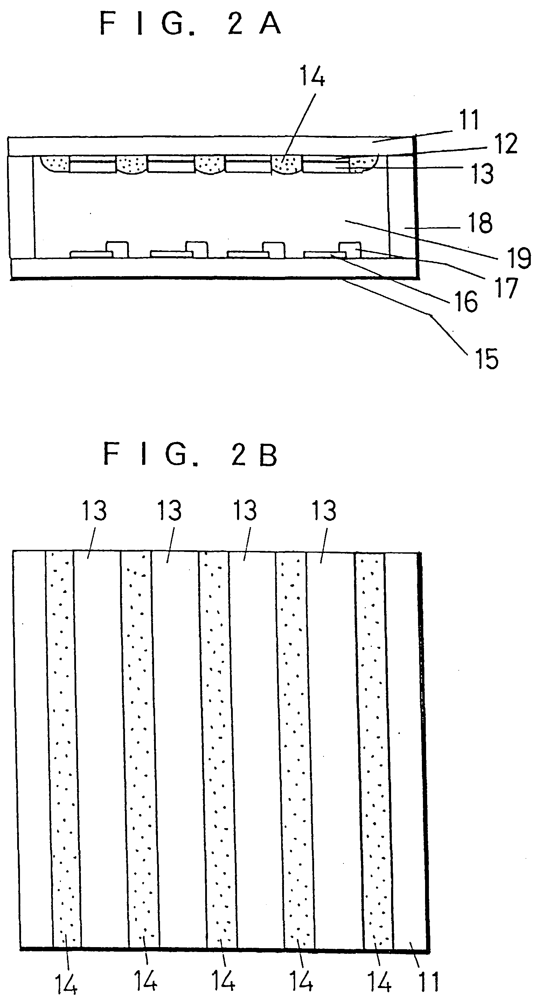

Figs. 2a and 2b are sectional and frontal views of a prior art colour liquid crystal display. In the figures, the reference numerals denote a glass substrate 11, transparent electrodes 12 composed of ITO or the like and patterned into stripes, colour filters 13 created on the transparent electrodes 12 by way of electro-deposition, light shielding layers 14 formed only in the gaps between colour filters by applying a photosensitive substance containing a light shielding substance such as carbon on the colour filters 13 and by exposing and developing it from the opposite side of the face where the colour filters are formed by utilising the colour filters as masks, and a second glass substrate 15 on which transparent electrodes 16 and thin film transistors 17 are formed. The colour liquid crystal display is formed by pasting the colour filter substrate 11 and the thin film transistor substrate 15 thus formed together by a sealing compound 18 so as to keep a predetermined gap therebetween and filling liquid crystal 19 in the gap.

The colour liquid crystal display thus formed has good contrast owing to switching characteristics of the thin film transistor, and the colour filters are formed simply by electro-deposition, so that a high quality and low cost colour display may be obtained.

However, although the colour liquid crystal display of the prior art is simple to make because the light shielding layer is formed in self-alignment utilising the colour filters as the masks, no light shielding layer is formed inevitably where there is the colour filter. Further, although the colour filter is simple to make because it is formed by way of electro-deposition, it requires a wiring for feeding electricity and the colour filter is inevitably formed at part where there is no pixel.

Thus, in the prior art display, the whole periphery of the pixel could not be surrounded by the light shielding layer. Further, although the display using the thin film transistor allowed a high contrast, its characteristics is apt to be changed by light, and it has been necessary to shield outside light to stabilise its operation.

Accordingly, it is desirable to eliminate the leakage of light from the periphery of the pixel, which had been unavoidable in the prior art method, to completely shield the periphery of the pixel. If this can be done, the operation of the thin film transistor may be stabilised and the contrast may be improved further as stray light is eliminated.

According to a first aspect of the inverntion, there is provided a method of manufacturing a liquid crystal display, the method including forming a plurality of electrodes on a substrate, electro-depositing filters on the electrodes, forming a light shielding layer such that the light shielding layer does not cover said filters, characterised in that an insulative resist is formed on the electrodes prior to electro-depositing said filters, the pattern of the insulative resist defining the location of the filters.

The filters may be formed to have a thickness greater than that of the insulative resist, and the insulative resist may have the minimum thickness required to prevent electro-deposition of the filters thereon.

The filters may be formed by electro-depositing cationic polymers, the insulative resist may be alkali-soluble, and the insulative resist may be removed after electro-depositing the filters.

According to a second aspect of the inverntion, there is provided a method for manufacturing a multicolour liquid crystal display using colour filters comprising:
a step of forming and patterning a plurality of electrodes on a substrate;
a step of forming and patterning an insulative resist on the plurality of electrodes;
a step of forming and electro-depositing colour filters on the plurality of electrodes by selectively energising them such that the thickness of colour filters are thicker than that of the insulating resist;
a step of forming a light shielding substance on the colour filters; and
a step of exposing the light shielding substance from the opposite side of the substrate of which the colour filters are formed by utilising the colour filters as photo-masks for patterning the light shielding substance so as to be left on the parts where the colour filters are not formed.

According to a third aspect of the inverntion, there is provided a method for manufacturing a multicolour liquid crystal display using colour filters comprising:
a step of forming and patterning a plurality of electrodes on a substrate;
a step of forming and patterning an insulative resist on the plurality of electrodes;
a step of forming and electro-depositing cationic polymers to be colour filters on the plurality of electrodes by selectively energising them;
a step of removing the insulative resist alkali;
a step of forming a light shielding substance on the colour filters; and
a step of exposing the light shielding substance from the opposite side of the substrate of which the colour filters are formed by utilising the colour filters as photo-masks for patterning the light shielding substance so as to be left on the parts where the colour filters are not formed.

By such methods, the periphery of the pixel of the colour display combined with a thin film transistor may be completely shielded and the leakage of light from the periphery of the pixel may be eliminated.

In another aspect, the method may comprise;
1) patterning an insulating resist on a plurality of electrodes formed on a substrate;
2) selectively energising the plurality of electrodes to form colour filters by way of electro-deposition on the electrodes;
3) Forming a light shielding substance on the colour filters; and
4) exposing the light shielding substance from the opposite side from the substrate face where the colour filters have been formed by utilising the colour filters as a mask to pattern the light shielding substance so as to leave it only at the gap between the colour filters. Thereby, in the colour liquid crystal display in which the operation of the thin film transistor is stabilised, stray light may be eliminated and the display quality and the contrast may be improved.

The point of the present invention, in one aspect, lies in that how dot-shaped colour filters separated from each other in an isolated manner can be formed by way of electro-deposition. It is necessary to coat insulative resist on a part of a pixel electrode so as not to cause electro-deposition on that part. A problem of this method, because the insulating resist is a useless layer when forming a light shielding layer later, is that of how the insulating layer should be handled so that it will not hamper the formation of the light shielding layer. One could attempt to remove the insulating resist without damaging the colour filters. However, because both the colour filter and the insulating resist are resin, it is difficult to remove selectively only one of them. According to one aspect of the present invention, solutions for solving each problem have been found.

For the first problem, a method of forming the insulating resist to be relatively thinner than the colour filter and of forming the light shielding layer thereon without peeling off the insulating resin was found. According to this method, although the light shielding layer on the electrode becomes thicker than the light shielding layer at the gap between the colour filters by the insulating resin, there exists less difference in level, thus causing no disturbance of orientation of the liquid crystal display, because the thickness of the resist is thinned to the minimum requirement which causes no electro-deposition. That is, it is a simple method requiring no process for peeling the insulating resin.

For the other problem, a method of selecting an alkali as a peeling agent in peeling the insulating resin and of selecting a cationic resin as a resin to be electro-deposited was found. As a photoresist, generally there are solvent peeling type, alkali peeling type, nitric acid peeling type photoresists. In the solvent peeling, the colour filter resin is apt to cause a swelling and to be dissolved because a strong organic solvent is used. In the nitric acid peeling, because the resin is oxidised and decomposed, the colour filter resin is also oxidised and decomposed in the same manner. In the alkali peeling, the colour filter is not eroded in peeling and the insulating resin as long as a type of resin which is not neutralised and dissolved by alkali is selected as the colour filter resin because the peeling is carried out by neutral dissolution of a functional group of the resin.

As a typical photoresist, a phenolic novolak resin or the like is used as a positive resin and a substrate resin such as a synthetic rubber is used as a negative resin. While there are various types of peeling agents such as the alkali, nitric acid and solvent type peeling agents, the alkali dissolution type agent is commercially available.

As the electro-deposition, there are two types of resin of an anion type in which poly-carboxylic acid is neutralised by alkali such as amine and a cation type in which poly-amine is neutralised by acid. While the anion type is electro-deposited at the anode, the deposited film is essentially an alkali-soluble type film and the colour filters are eroded by the alkali when the insulating resin is peeled by the alkali after forming the colour filters by way of electro-deposition.

In contrast, in the cation type, because the colour filter is deposited at the cathode and the deposited film is essentially oxide-soluble and alkali-insoluble, the colour filters are not eroded when the insulating resin is peeled off by the alkali and the insulating resin can be peeled off readily. As the cation type electro-deposition resin, there are acrylic resin, epoxy resin, urethane resin, polybutadiene resin, polyamide resin and the like, and they are used singularly, in a mixed form or in combination with a bridging resin such as urethane resin and polyesther resin. All of the resins have a basic functional group such as amino group and an onium group such ammonium, sulfonium, phosfonium within the molecules and is used in a manner solubilized in water by acid or acid substance such as acetic acid, formic acid, propionic acid and lactic acid.

When the light shielding film is formed in self-alignment by utilising the colour filters as masks in the same manner with the prior art technology after forming the colour filters in accordance with a desired pixel shape, not in stripes, the light shielding film covers the whole periphery of the pixel, thus enchancing the light shielding performance and providing an excellent display quality.

For a better understanding of the invention embodiments will now be described, by way of example, with reference to the accompanying drawings, in which:-
Fig. 1 is a sectional view of a multicolour liquid crystal display according to the present invention;
Figs. 2a and 2b are section and frontal views of a prior art multicolour liquid crystal display;
Figs. 3a through 3d' are views showing a manufacturing process of a colour filter substrate according to the present invention; and
Figs. 4a through 4e' are views showing another manufacturing process of a colour filter substrate according to the present invention.

### [First Embodiment]

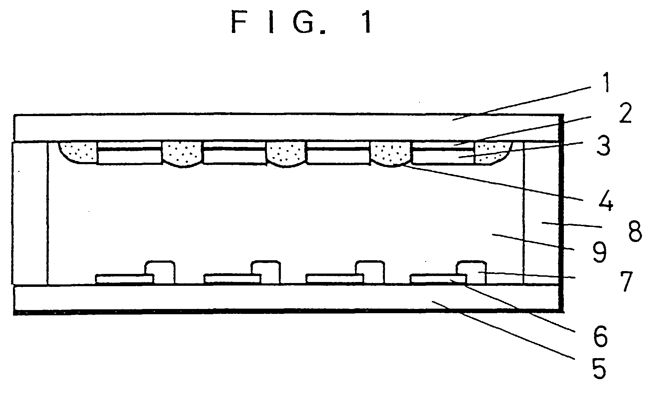

Fig. 1 shows a section view of a multicolour liquid crystal display according to the present invention. In the figure, the reference numerals denotes a glass substrate 1, transparent electrodes 2 composed of ITO or the like and patterned into stripes, colour filters 3 created on the transparent electrodes 2 by way of electro-deposition so that their shape coincides with a pixel, light shielding layers 4 formed by applying a photosensitive substance containing a light shielding substance such as carbon on the colour filters 3 and by exposing and developing it from the opposite side of the face where the colour filters are formed by utilising the colour filters as masks so that they cover the periphery of the colour filters.

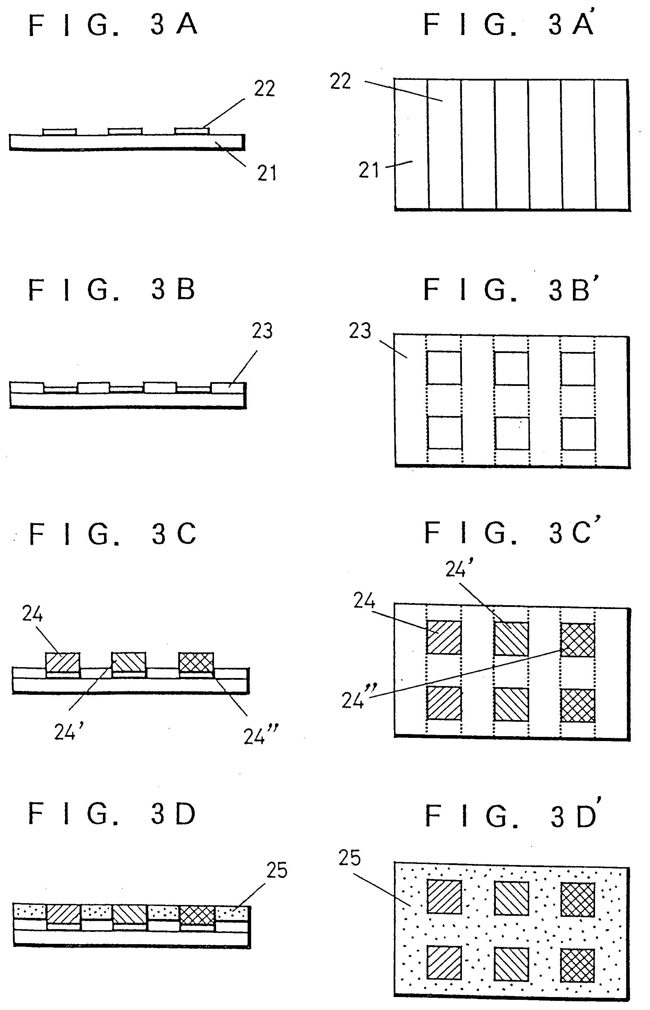

Figs. 3a through 3d' show the method for creating the above-mentioned colour filter substrate by section views and frontal views thereof.

In Figs. 3a and 3a', the reference numerals denote a glass substrate 21 and transparent electrodes 22 are formed in stripes by forming ITO and then patterning it.

In Figs. 3b and 3b', 0.1 µm of negative resist (V-259-PA, produced by Nippon Steel Chemical Co., Ltd.) was applied on the transparent electrodes 22. After that, it was exposed into a shape of desirable pixel and then developed by sodium carbonate solution to form insulating resists 23.

In Figs. 3c and 3c', a group of pixels to be coloured red was selected among the transparent electrodes 22, the transparent electrodes 22 anodised by an anionic polyester electro-deposition resin and dispersed solution of red pigment, and red colour filters 24 were formed by electro-deposition. Next, the same operation was repeated for green and blue to create colour filters 24' and 24'' with 1.5 µm of thickness.

In Figs. 3d and 3d', a black resist in which carbon was mixed into negative resist (V-259-PA, produced by Nippon Steel Chemical Co., Ltd.) was applied to colour filters, was exposed from the back side utilising the colour filters as masks and was developed to form a light shielding film 25.

The colour filter substrate thus fabricated could be simply formed without being eroded by the strong alkali used in peeling off the insulating resist.

Returning to Fig. 1, the multicolour liquid crystal display is formed by pasting the colour filter substrate 1 thus formed in the manner completely shielding the periphery of the colour filter pixels and a second glass substrate 5 on which pixel transparent electrodes 6 and thin film transistors 7 are formed together by a sealing compound 8 so as to keep a predetermined gap therebetween and by filling liquid crystal 9 in the gap.

Even though the multicolour liquid crystal display is fabricated thus by the simple method, the periphery of the pixels is completely shielded and there is no degradation of the characteristic of the thin film transistor, thus showing a high display quality. Further, because the light shielding film has a difference in level of only 0.1 µm of the insulating resist, it allows a homogeneous orientation to be maintained, causing no orientation disorder.

### [Second Embodiment]

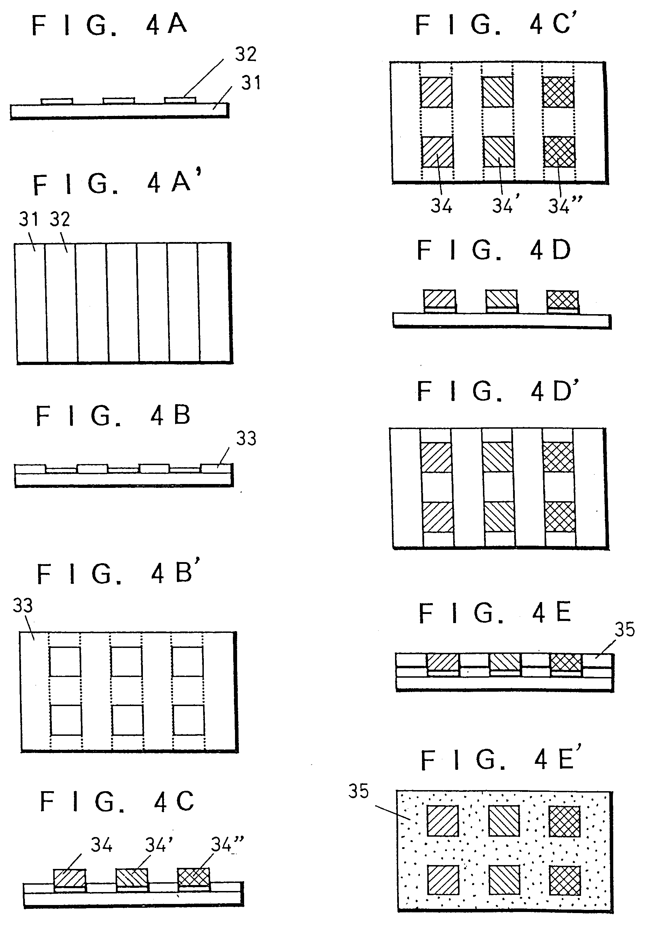

The colour filter substrate in the first embodiment was fabricated by a method shown in section views and frontal views in Figs. 4a through 4e'.

In Figs. 4a and 4a', the reference numeral 31 denotes a glass substrate, and transparent electrodes 32 are formed in stripes by forming ITO and then patterning it.

In Figs. 4b and 4b', 1 µm of positive resist (OFPR-800, produced by Tokyo Ohka Kogyo Co., Ltd.) was applied on the transparent electrode 32. After that, it was exposed in a shape of desirable pixel and then developed by sodium carbonate solution to form an insulating resist 33.

In Figs. 4c and 4c', a group of pixels to be coloured red was selected among the transparent electrodes 32, the transparent electrodes 32 was cathodized by a cationic acrylic electro-deposition resin and dispersed solution of red pigment, and red colour filters 34 were formed by way of electro-deposition. Next, the same operation was repeated for green and blue to create colour filters 34' and 34'' with 1.5 µm of thickness.

In Figs. 4d and 4d', the insulating resist 33 was dissolved and peeled off by a strong alkali such as NaOH, KOH and tetramethylammonium hydroxide.

In Figs. 4e and 4e', a negative black resist (CK-5002, produced by Fuji-Hunt Electronics Technology Co., Ltd.) was applied on the colour filters, was exposed from the back side utilising the colour filters as masks and was developed to form a light shielding film 35.

Note that because alkali used in the development was much weaker than one used in peeling, the colour filter was not eroded as long as it had been hardened.

When the multicolour liquid crystal display was fabricated in the same manner with the first embodiment, the same effects with the first embodiment could be obtained.

As explained in detail in the aforementioned embodiments, a method for manufacturing a multicolour liquid crystal display allows a periphery of pixels of a multicolour display combined with thin film transistors to be completely shielded and the leakage of light from the periphery of the pixels to be eliminated without hampering the advantages of the simple processes of forming colour filters by way of electro-deposition and of forming the light shielding film in self-alignment by fabricating the colour filter substrate of steps of:
1) patterning insulating resist on a plurality of electrodes formed on a substrate;
2) selectively energising the plurality of electrodes to form colour filters by way of electro-deposition on the electrodes;
3) forming a light shielding substance on the colour filters; and
4) exposing the light shielding substance from the opposite side from the substrate face where the colour filters have been formed by utilising the colour filters as masks to pattern the light shielding substance so as to leave it only at the gap between the colour filters. Thereby, the multicolour liquid crystal display in which the operation of the thin film transistor is stabilised, stray light is eliminated and the display quality and the contrast are improved may be provided at low cost.

## Claims

1. A method of manufacturing a liquid crystal display, the method including forming a plurality of electrodes (2,22,32) on a substrate (1,21,31), electro-depositing filters (3,24,34) on the electrodes, forming a light shielding layer (4,25,35) such that the light shielding layer does not cover said filters, characterised in that an insulative resist (23,33) is formed on the electrodes prior to electro-depositing said filters, the pattern of the insulative resist defining the location of the filters.

2. A method according to claim 1, wherein the filters (3,24,34) are formed to have a thickness greater than that of said insulative resist (23,33).

3. A method according to claim 2, wherein the insulative resist (23,33) is formed such that it has the minimum thickness required to prevent electro-deposition of the filters (3,24,34) thereon.

4. A method according to claim 1, wherein the filters (3,24,34) are formed by electro-depositing cationic polymers, the insulative resist (23,33) is alkali-soluble, and the insulative resist (23,33) is removed after electro-depositing the filters (3,24,34).

5. A method for manufacturing a multicolour liquid crystal display using colour filters comprising:
a step of forming and patterning a plurality of electrodes on a substrate;
a step of forming and patterning an insulative resist on the plurality of electrodes;
a step of forming and electro-depositing colour filters on the plurality of electrodes by selectively energising them such that the thickness of colour filters are thicker than that of the insulating resist;
a step of forming a light shielding substance on the colour filters; and
a step of exposing the light shielding substance from the opposite side of the substrate of which the colour filters are formed by utilising the colour filters as photo-masks for patterning the light shielding substance so as to be left on the parts where the colour filters are not formed.

6. A method for manufacturing a multicolour liquid crystal display using colour filters comprising:
a step of forming and patterning a plurality of electrodes on a substrate;
a step of forming and patterning an insulative resist on the plurality of electrodes;
a step of forming and electro-depositing cationic polymers to be colour filters on the plurality of electrodes by selectively energising them;
a step of removing the insulative resist alkali;
a step of forming a light shielding substance on the colour filters; and
a step of exposing the light shielding substance from the opposite side of the substrate of which the colour filters are formed by utilising the colour filters as photo-masks for patterning the light shielding substance so as to be left on the parts where the colour filters are not formed.

7. The method for manufacturing the multicolour liquid crystal display according to claim 5 or 6, wherein said light shielding substance has a photosensitivity.

8. The method for manufacturing the multicolour liquid crystal display according to claim 5, 6 or 7, wherein said multicolour display applying said colour filters in an active matrix type display equipped with thin film transistors.
